(19) Europäisches Patentamt
European Patent Office
Office européen des brevets

(11) **EP 4 365 962 A1**

(12) **EUROPEAN PATENT APPLICATION**
published in accordance with Art. 153(4) EPC

(43) Date of publication:
**08.05.2024  Bulletin 2024/19**

(21) Application number: **22862755.0**

(22) Date of filing: **26.05.2022**

(51) International Patent Classification (IPC):
**H01L 31/068** (2012.01)      **H01L 31/0747** (2012.01)
**H01L 31/075** (2012.01)

(52) Cooperative Patent Classification (CPC):
**H01L 31/068; H01L 31/0747; H01L 31/075;
H10K 30/40; H10K 30/50; H10K 30/87;
H10K 39/15;** Y02E 10/549

(86) International application number:
**PCT/CN2022/095203**

(87) International publication number:
**WO 2023/029613 (09.03.2023 Gazette 2023/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **01.09.2021  CN 202111022824**

(71) Applicant: **Longi Green Energy Technology Co.,
Ltd.**
**Xi'an, Shaanxi 710100 (CN)**

(72) Inventors:
 • **WU, Zhao**
 **Shaanxi 710100 (CN)**

 • **XU, Chen**
 **Shaanxi 710100 (CN)**
 • **XIE, Junjie**
 **Shaanxi 710100 (CN)**
 • **LI, Zifeng**
 **Shaanxi 710100 (CN)**
 • **LIU, Tong**
 **Shaanxi 710100 (CN)**

(74) Representative: **Loo, Chi Ching et al
Albright IP Limited
County House
Bayshill Road
Cheltenham, Gloucestershire GL50 3BA (GB)**

(54) **LAMINATED SOLAR CELL AND PHOTOVOLTAIC ASSEMBLY**

(57)    The present application provides a tandem solar cell and a photovoltaic assembly, which relates to the technical field of solar photovoltaics. The tandem solar cell includes: a top-layer perovskite sub-cell and a bottom-layer crystalline-silicon sub-cell, and an optical regulating layer provided between the top-layer perovskite sub-cell and the bottom-layer crystalline-silicon sub-cell. In the present application, the top-layer perovskite sub-cell cannot completely absorb the target light rays whose wavelengths are within the short-wave wave band in the range of 600-800 nanometers among the sunlight rays. After the part of the target light rays that are not absorbed by the top-layer perovskite sub-cell have passed through the top-layer perovskite sub-cell, because the optical regulating layer can be used to reflect at least some of the target light rays back into the top-layer perovskite sub-cell, at least some of the target light rays can enter the top-layer perovskite sub-cell again to perform secondary absorption, which prevents that the target light rays within the short-wave wave band directly enter the bottom-layer crystalline-silicon sub-cell having a low utilization ratio of the target light rays within the short-wave wave band, thereby increasing the efficiency of the tandem solar cell.

FIG. 1

**Description**

CROSS REFERENCE TO RELEVANT APPLICATIONS

The present application claims the priority of the Chinese patent application filed on September 01st, 2021 before the Chinese Patent Office with the application number of 202111022824.5 and the title of "LAMINATED SOLAR CELL AND PHOTOVOLTAIC ASSEMBLY", which is incorporated herein in its entirety by reference.

TECHNICAL FIELD

The present application relates to the technical field of solar photovoltaics, and particularly relates to a tandem solar cell and a photovoltaic assembly.

BACKGROUND

In order to solve the continuous consumption of and the negative influence on the environment by traditional energy sources, the exploitation and utilization of solar energy, as a pollution-free renewable energy source, is rapidly developed.

Because the solar spectrum has a wide energy distribution, and any semiconductor material can merely absorb the photons whose energy value is greater than their band gap, in order to utilize the solar energy to the utmost extent, in recent years, tandem-solar-cell systems are paid extensive attention in the field of solar cells. For example, regarding crystalline-silicon solar cells, as restricted by their indirect-band-gap semiconductor of the silicon material having a band gap of 1.12 electron volts, the theoretic limit of their photoelectric conversion efficiency is approximately 29.4%. A perovskite cell may be overlaid on the crystalline-silicon solar cell, to form a two-end two-junction tandem solar cell, in which the perovskite cell located at the top layer may absorb the sunlight of the higher energies (short wave), and the crystalline-silicon solar cell located at the bottom layer can absorb the sunlight of the lower energies (long wave), which can convert the light energy into electric energy to the utmost extent, to enable the photoelectric conversion efficiency of the tandem solar cell to exceed 30%.

However, in conventional solutions, the perovskite cell located at the top layer cannot completely absorb all of the light rays within the short-wave wave band among the sunlight rays to convert them into electric energy, but transmits a certain quantity of the light rays within the short-wave wave band (for example, the wavelengths of 600-800 nanometers) to the crystalline-silicon solar cell at the bottom layer. Moreover, because the crystalline-silicon solar cell has a low utilization ratio to the light rays within the short-wave wave band, the tandem-solar-cell system has a low overall efficiency.

SUMMARY

The present application provides a tandem solar cell and a photovoltaic assembly, which aims at solving the problem of a low overall efficiency of tandem-solar-cell systems.

In the first aspect, an embodiment of the present application provides a tandem solar cell, where the tandem solar cell includes:

a top-layer perovskite sub-cell and a bottom-layer crystalline-silicon sub-cell, and an optical regulating layer provided between the top-layer perovskite sub-cell and the bottom-layer crystalline-silicon sub-cell;
the top-layer perovskite sub-cell is provided at a light facing surface of the tandem solar cell, the bottom-layer crystalline-silicon sub-cell is provided at a shadow surface of the tandem solar cell, and the top-layer perovskite sub-cell and the bottom-layer crystalline-silicon sub-cell are electrically connected to each other; and
the optical regulating layer is for reflecting at least some of target light rays that pass through the top-layer perovskite sub-cell among sunlight rays back into the top-layer perovskite sub-cell, where the target light rays refer to light rays whose wavelengths are in a range of 600-800 nanometers among the sunlight rays.

Optionally, a maximum value of a reflectivity to the target light rays of the optical regulating layer is greater than or equal to a preset reflectivity.

Optionally, an average reflectivity to the target light rays of the optical regulating layer is greater than or equal to a preset reflectivity.

Optionally, reflectivities to all of the target light rays of the optical regulating layer are greater than or equal to a preset reflectivity.

Optionally, the preset reflectivity is 30%-100%.

Optionally, the preset reflectivity is $50 \pm 10\%$.

Optionally, the optical regulating layer includes at least one low-refractive-index layer and at least one high-refractive-index layer; and
the at least one low-refractive-index layer and the at least one high-refractive-index layer are separate.

Optionally, the low-refractive-index layer includes a low-refractive-index material whose refractive index is less than or equal to a first preset refractive index, and the high-refractive-index layer includes a high-refractive-index material whose refractive index is greater than or equal to a second preset refractive index, where the first preset refractive index is less than or equal to the second preset refractive index; and
the refractive index of the low-refractive-index material and the refractive index of the high-refractive-index material, a thickness of the low-refractive-index layer and a thickness of the high-refractive-index layer, and a quantity of the low-refractive-index layers and a quantity of the high-refractive-index layers are decided according to the wavelength range of 600-800 nanometers and the preset reflectivity.

Optionally, a refractive index of the low-refractive-index layer is less than or equal to 1.5, and a refractive index of the high-refractive-index layer is greater than or equal to 1.9.

Optionally, the low-refractive-index material includes at least one of silicon oxide, silicon oxynitride, sodium fluoride, lithium fluoride, magnesium fluoride, calcium fluoride, sprio-OMe TAD and a fullerene derivative; and
the high-refractive-index material includes at least one of carbon-60, diamond, titanium oxide, molybdenum oxide, tungsten oxide, vanadium oxide, zinc oxide, aluminum nitride, zirconium oxide, silicon nitride, silicon oxynitride, aluminum oxynitride, tungsten sulfide, molybdenum sulfide, lead sulfide, boron carbide, silicon carbide, bismuth ferrite, lead iodide, titanium nitride, vanadium nitride, boron phosphide, gallium phosphide, indium phosphide, phosphor germanium zinc, aluminum antimonide, gallium antimonide, indium antimonide, bismuth selenide, molybdenum selenide, lead selenide, tungsten selenide, zinc telluride, lead telluride and molybdenum telluride.

Optionally, the top-layer perovskite sub-cell includes a perovskite light absorbing layer, a first charge-carrier transporting layer, a second charge-carrier transporting layer and a first electrode, and the bottom-layer crystalline-silicon sub-cell includes a crystalline-silicon light absorbing layer, a third charge-carrier transporting layer, a fourth charge-carrier transporting layer and a second electrode;

the first charge-carrier transporting layer is provided at a light facing surface of the perovskite light absorbing layer, the second charge-carrier transporting layer is provided at a shadow surface of the perovskite light absorbing layer, a charge-carrier selectivity corresponding to the first charge-carrier transporting layer and a charge-carrier selectivity corresponding to the second charge-carrier transporting layer are opposite, and the first electrode is provided on one side of the light facing surface of the perovskite light absorbing layer;
the third charge-carrier transporting layer is provided at a light facing surface of the crystalline-silicon light absorbing layer, the fourth charge-carrier transporting layer is provided at a shadow surface of the crystalline-silicon light absorbing layer, a charge-carrier selectivity corresponding to the third charge-carrier transporting layer and a charge-carrier selectivity corresponding to the fourth charge-carrier transporting layer are opposite, and the second electrode is provided on one side of the shadow surface of the crystalline-silicon light absorbing layer; and
the charge-carrier selectivity corresponding to the second charge-carrier transporting layer and the charge-carrier selectivity corresponding to the third charge-carrier transporting layer are opposite.

Optionally, the second charge-carrier transporting layer and the third charge-carrier transporting layer are electrically connected to each other, to realize electric connection between the top-layer perovskite sub-cell and the bottom-layer crystalline-silicon sub-cell.

Optionally, the tandem solar cell further includes an electrically conducting component; and
the second charge-carrier transporting layer and the third charge-carrier transporting layer are electrically connected to each other by the electrically conducting component.

Optionally, a through hole or slot component penetrating the optical regulating layer is provided in the optical regulating layer, the electrically conducting component is provided in the through hole or slot component of the optical regulating layer, one end of the electrically conducting component is connected to the second charge-carrier transporting layer, and the other end of the electrically conducting component is connected to the third charge-carrier transporting layer.

Optionally, a ratio of an area of a projection on the light facing surface of the through hole or slot component in the optical regulating layer to an area of a projection of the optical regulating layer on the light facing surface is less than 20%.

Optionally, the electrically conducting component is provided at a component side position of the tandem solar cell; and
one end of the electrically conducting component is connected to the second charge-carrier transporting layer, and the other end of the electrically conducting component is connected to the third charge-carrier transporting layer.

Optionally, the electrically conducting component includes at least one of a transparent electrically conductive material, a metal material and a mixed material including multiple types of metals, where the transparent electrically conductive material includes at least one of indium tin oxide and aluminum-doped zinc oxide.

Optionally, the optical regulating layer contains an electrically conductive material; and
the second charge-carrier transporting layer and the third charge-carrier transporting layer are electrically connected to each other by the optical regulating layer.

Optionally, the tandem solar cell further includes a first passivation layer, a first anti-reflection layer and a second passivation layer;

the first passivation layer is provided between the first charge-carrier transporting layer and the perovskite light absorbing layer, and the first anti-reflection layer is provided at one surface of the first charge-carrier transporting layer that is close to the perovskite light absorbing layer; and
the second passivation layer is provided between the second charge-carrier transporting layer and the perovskite light absorbing layer.

Optionally, the tandem solar cell further includes a third passivation layer, a fourth passivation layer and a second anti-reflection layer;

the third passivation layer is provided between the third charge-carrier transporting layer and the crystalline-silicon light absorbing layer; and
the fourth passivation layer is provided between the fourth charge-carrier transporting layer and the crystalline-silicon light absorbing layer, and the second anti-reflection layer is provided at one surface of the fourth charge-carrier transporting layer that is close to the crystalline-silicon light absorbing layer.

Optionally, one end of the first electrode is provided at a light facing surface of the perovskite light absorbing layer, or provided at a light facing surface of the first charge-carrier transporting layer, or provided inside the first charge-carrier transporting layer, and the other end of the first electrode passes through the first charge-carrier transporting layer and protrudes out of one surface of the first charge-carrier transporting layer that is away from the perovskite light absorbing layer; and
one end of the second electrode is provided at a shadow surface of the crystalline-silicon light absorbing layer, or provided at a shadow surface of the fourth charge-carrier transporting layer, or provided inside the fourth charge-carrier transporting layer, and the other end of the second electrode passes through the fourth charge-carrier transporting layer and protrudes out of one surface of the fourth charge-carrier transporting layer that is away from the crystalline-silicon light absorbing layer.

Optionally, the third charge-carrier transporting layer is a charge-carrier transporting layer that is obtained by performing in-situ doping to the light facing surface of the crystalline-silicon light absorbing layer, and the fourth charge-carrier transporting layer is a charge-carrier transporting layer that is obtained by performing in-situ doping to the shadow surface of the crystalline-silicon light absorbing layer.

In the second aspect, an embodiment of the present application provides a photovoltaic assembly, where the photovoltaic assembly includes the tandem solar cell according to any one of the above embodiments.

Based on the tandem solar cell and the photovoltaic assembly, the present application has the following advantageous effects. In the present application, the top-layer perovskite sub-cell cannot completely absorb the target light rays whose wavelengths are within the short-wave wave band in the range of 600-800 nanometers among the sunlight rays. After the part of the target light rays that are not absorbed by the top-layer perovskite sub-cell have passed through the perovskite sub-cell, because the optical regulating layer provided between the top-layer perovskite sub-cell and the bottom-layer crystalline-silicon sub-cell is for reflecting at least some of the target light rays back into the top-layer perovskite sub-cell, at least some of the target light rays within the short-wave wave band are reflected by the optical regulating layer and enter the top-layer perovskite sub-cell again, for the top-layer perovskite sub-cell to perform secondary absorption to the target light rays within the short-wave wave band, which prevents that some of the target light rays within the short-wave wave band directly enter the bottom-layer crystalline-silicon sub-cell having a low utilization ratio of the target light rays within the short-wave wave band, thereby increasing the efficiency of the tandem solar cell.

BRIEF DESCRIPTION OF THE DRAWINGS

In order to more clearly illustrate the technical solutions of the embodiments of the present application, the figures that are required to describe the embodiments of the present application will be briefly described below. Apparently, the figures that are described below are embodiments of the present application, and a person skilled in the art can obtain other figures according to these figures without paying creative work.

FIG. 1 shows a schematic structural diagram of a first type of the tandem solar cell according to an embodiment of the present application;
FIG. 2 shows a schematic diagram of the external quantum efficiency of a tandem solar cell according to an embodiment of the present application;
FIG. 3 shows a schematic diagram of the external quantum efficiency of another tandem solar cell according to an embodiment of the present application;
FIG. 4 shows a schematic structural diagram of an optical regulating layer according to an embodiment of the present application;
FIG. 5 shows a schematic structural diagram of a second type of the tandem solar cell according to an embodiment of the present application;
FIG. 6 shows a schematic structural diagram of a third type of the tandem solar cell according to an embodiment of the present application;
FIG. 7 shows a schematic structural diagram of a fourth type of the tandem solar cell according to an embodiment of the present application;
FIG. 8 shows a schematic structural diagram of a fifth type of the tandem solar cell according to an embodiment of the present application;
FIG. 9 shows a schematic diagram of the reflection of a suede structure of a crystalline-silicon light absorbing layer according to an embodiment of the present application;
FIG. 10 shows a curve of the reflectivity of a first type of the optical regulating layer according to an embodiment of the present application;
FIG. 11 shows a curve of the reflectivity of a second type of the optical regulating layer according to an embodiment of the present application;
FIG. 12 shows a curve of the reflectivity of a third type of the optical regulating layer according to an embodiment of the present application;
FIG. 13 shows a curve of the reflectivity of a fourth type of the optical regulating layer according to an embodiment of the present application; and
FIG. 14 shows a curve of the reflectivity of a fifth type of the optical regulating layer according to an embodiment of the present application.

Description of the reference numbers:

10-top-layer perovskite sub-cell, 11-perovskite light absorbing layer, 12-first charge-carrier transporting layer, 13-second charge-carrier transporting layer, 20-bottom-layer crystalline-silicon sub-cell, 21-crystalline-silicon light absorbing layer, 22-third charge-carrier transporting layer, 23-fourth charge-carrier transporting layer, 30-optical regulating layer, 31-low-refractive-index layer, 32-high-refractive-index layer, 40-electrically conducting component, 50-first electrode, and 60-second electrode.

## DETAILED DESCRIPTION

The technical solutions of the embodiments of the present application will be clearly and completely described below with reference to the drawings of the embodiments of the present application. Apparently, the described embodiments are merely certain embodiments of the present application, rather than all of the embodiments. All of the other embodiments that a person skilled in the art obtains on the basis of the embodiments of the present application without paying creative work fall within the protection scope of the present application.

The tandem solar cell and the fabricating method, and the photovoltaic assembly according to the present application will be described in detail below with reference to the particular embodiments.

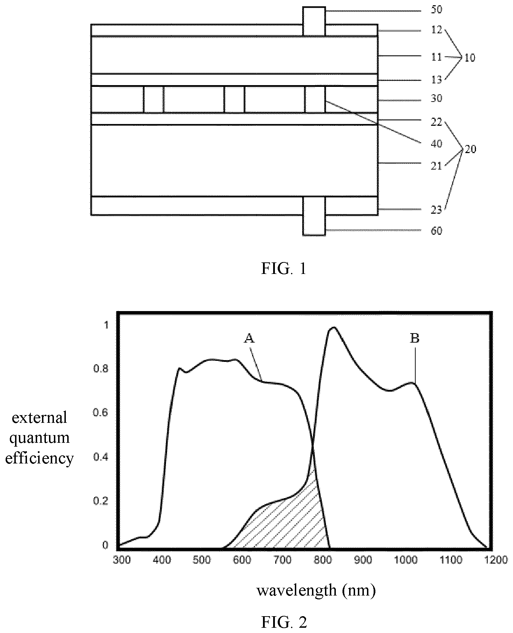

FIG. 1 shows a schematic structural diagram of a first type of the tandem solar cell according to an embodiment of the present application. Referring to FIG. 1, the tandem solar cell may include: a top-layer perovskite sub-cell 10 and a bottom-layer crystalline-silicon sub-cell 20, and an optical regulating layer 30 provided between the top-layer perovskite sub-cell 10 and the bottom-layer crystalline-silicon sub-cell 20.

The top-layer perovskite sub-cell 10 is provided at the light facing surface of the tandem solar cell, the bottom-layer crystalline-silicon sub-cell 20 is provided at the shadow surface of the tandem solar cell, and the top-layer perovskite sub-cell 10 and the bottom-layer crystalline-silicon sub-cell 20 are electrically connected to each other.

Currently, crystalline-silicon solar cells and assemblies are the major part of the photovoltaics market. The techniques for the fabrication of crystalline-silicon devices and assemblies are becoming increasingly mature, the fabrication cost and the kilowatt-hour cost are gradually decreasing, and the power increasing of single assemblies and the increasing of the device efficiency have become the most effective approach to realize "fair-price net surfing". However, regarding crystalline-silicon solar cells, as restricted by the characteristics of their indirect-band-gap semiconductor of the silicon (Si) material having a band gap of 1.12 electron volts, the theoretic limit (S-Q limit) of their photoelectric conversion efficiency (Power Conversion Efficiency, PCE) is approximately 29.4%.

A wide-band-gap perovskite upper-layer device may be overlaid on the crystalline-silicon solar cell, to form a two-end two-junction tandem photovoltaic device, which can be expected to obtain a photoelectric conversion efficiency above 30%. Moreover, such a structure has the potential to realize low-cost large-scale mass production. In other words, the crystalline-silicon solar cell is used as the bottom-layer sub-cell, and the perovskite cell is overlaid at its light facing surface to be used as the top-layer sub-cell, thereby forming a tandem solar cell.

In the embodiments of the present application, the top-layer sub-cell corresponding to the tandem solar cell is the top-layer perovskite sub-cell 10, which is provided at the light facing surface of the tandem solar cell. The bottom-layer sub-cell is the bottom-layer crystalline-silicon sub-cell 20, which is provided at the shadow surface of the tandem solar cell. Accordingly, when the sunlight rays are irradiating the tandem solar cell, they firstly enter the top-layer perovskite sub-cell 10 located at the top layer. Because the light absorber in the top-layer perovskite sub-cell 10 is a perovskite material having a higher band gap, it can absorb the high-energy photons (corresponding to the light rays within the short-wave wave band) in the sunlight rays to perform photovoltaic conversion. However, the low-energy photons (corresponding to the light rays within the long-wave wave band) in the sunlight rays pass through the top-layer perovskite sub-cell 10 and enter the bottom-layer crystalline-silicon sub-cell 20. Because the light absorber in the bottom-layer crystalline-silicon sub-cell 20 is a crystalline-silicon material having a lower band gap, it can absorb the low-energy photons (corresponding to the light rays within the long-wave wave band) in the sunlight rays to perform photovoltaic conversion. Finally, because the top-layer perovskite sub-cell 10 and the bottom-layer crystalline-silicon sub-cell 20 are electrically connected to each other, the electric energies generated by the photovoltaic conversion in the top-layer perovskite sub-cell 10 and the bottom-layer crystalline-silicon sub-cell 20 can be converged and exported from the tandem solar cell, to supply electric power to an external device.

FIG. 2 shows a schematic diagram of the external quantum efficiency of a tandem solar cell according to an embodiment of the present application. Referring to FIG. 2, the curve A is a curve of the variation of the external quantum efficiency (EQE) of the top-layer perovskite sub-cell 10 with the wavelength in the case in which the tandem solar cell is not provided with the optical regulating layer 30, and the curve B is a curve of the variation of the EQE of the bottom-layer crystalline-silicon sub-cell 20 with the wavelength in the case in which the tandem solar cell is not provided with the optical regulating layer 30. Because the numerical value of the external quantum efficiency is the ratio of the quantity of the collected electrons to the quantity of the incident photons, it can characterize the absorption coefficient of the cell to the light rays of a specific wavelength. In FIG. 2, the wavelength corresponding to the parts of the curve A and the curve B that overlap is in the range of approximately 600-800 nanometers, and the EQE of the top-layer perovskite sub-cell 10 to the light rays in that wave-band range decreases. Furthermore, the bottom-layer crystalline-silicon sub-cell 20 responds to the light rays in that wave-band range; in other words, the bottom-layer crystalline-silicon sub-cell 20 can also absorb the light rays in that wave-band range.

Accordingly, it can be known that, regarding the light rays whose wavelengths are in the wave-band range of 600-800 nanometers, when the light rays in that wave-band range are irradiating the tandem solar cell, the top-layer perovskite sub-cell 10 located at the top layer cannot completely absorb the light rays in that wave-band range to convert them into electric energy, but transmit a certain quantity of the light rays in that wave-band range to the bottom-layer crystalline-silicon sub-cell 20 at the bottom layer.

However, the light rays whose wavelengths are in the wave-band range of approximately 600-800 nanometers have thermal-energy loss in the bottom-layer crystalline-silicon sub-cell 20, which causes that the bottom-layer crystalline-silicon sub-cell 20 has a low energy utilization ratio to the light rays in that wave-band range; in other words, the bottom-layer crystalline-silicon sub-cell 20 has a low conversion efficiency to the light rays whose wavelengths are in the wave-band range of 600-800 nanometers.

In conclusion, because the part of the light rays whose wavelengths are in the range of approximately 600-800 nanometers (the short-wave wave band) cannot be completely absorbed by the top-layer perovskite sub-cell 10, the light rays within the short-wave wave band that are not absorbed by the top-layer perovskite sub-cell 10 enter the bottom-layer crystalline-silicon sub-cell 20. Moreover, the bottom-layer crystalline-silicon sub-cell 20 has a low energy utilization ratio, i.e., a low conversion efficiency, to the light rays within the short-wave wave band. As a result, the tandem-solar-cell system has a low overall conversion efficiency to the light rays within the wave band of 600-800 nanometers.

In the embodiments of the present application, the amount of absorption of the light rays in that wave-band range by the top-layer perovskite sub-cell 10 may be increased by increasing the thickness of the perovskite material serving as the light absorber in the top-layer perovskite sub-cell 10, to cause fewer light rays in that wave-band range to enter the bottom-layer crystalline-silicon sub-cell 20. However, an excessively high thickness reduces the efficiency of the separation and the transmission of the photon-generated carriers in the perovskite material, which reduces the efficiency of the top-layer perovskite sub-cell 10, and thus affects the overall efficiency of the tandem solar cell.

It should be noted that the areas corresponding to the curves in the diagrams of the external quantum efficiency may characterize the photo-generated currents generated by the sub-cells. In the tandem solar cell, electric-current adaptation is required between the sub-cells; in other words, it is required to ensure that the photo-generated currents generated by the top-layer perovskite sub-cell 10 and the bottom-layer crystalline-silicon sub-cell 20 have equal magnitudes. Referring to FIG. 2, if the areas corresponding to the curve A and the curve B are equal, it indicates that the electric currents of the top-layer perovskite sub-cell 10 and the bottom-layer crystalline-silicon sub-cell 20 are adapted. Currently, in conventional tandem solar cells, in order to realize the maximum test efficiency, the photo-generated currents of all of the sub-cells are adapted according to the AM 1.5G spectrum, and the adaptation mainly relies on the regulation on the thickness of the perovskite material in the top-layer perovskite sub-cell 10, to realize the complete absorption of the light rays within the short-wave wave band by the top-layer perovskite sub-cell 10, and, by regulating the band gap of the perovskite material in the top-layer perovskite sub-cell 10 at the upper layer, the allocation of the utilization on the spectral energy by the top-layer perovskite sub-cell 10 and the bottom-layer crystalline-silicon sub-cell 20 is regulated to realize the electric-current adaptation.

Further, by determining the light rays whose wavelengths are in the range of 600-800 nanometers among the sunlight rays as the target light rays, the optical regulating layer 30 may be provided between the top-layer perovskite sub-cell 10 and the bottom-layer crystalline-silicon sub-cell 20 of the tandem solar cell, so that the optical regulating layer 30 located between the top-layer perovskite sub-cell 10 and the bottom-layer crystalline-silicon sub-cell 20 can reflect at least some of the target light rays that pass through the top-layer perovskite sub-cell 10 among the sunlight rays back into the top-layer perovskite sub-cell 10.

Particularly, when the sunlight rays are irradiating the tandem solar cell, they firstly enter the top-layer perovskite sub-cell 10 located at the top layer. The top-layer perovskite sub-cell 10 cannot completely absorb the target light rays among the sunlight rays to perform photovoltaic conversion, and transmit a certain quantity of the target light rays to the optical regulating layer 30 between the top-layer perovskite sub-cell 10 and the bottom-layer crystalline-silicon sub-cell 20. Because the optical regulating layer 30 can reflect at least some of the target light rays that pass through the top-layer perovskite sub-cell 10 among the sunlight rays back into the top-layer perovskite sub-cell 10, the at least some of the target light rays are reflected by the optical regulating layer 30 and enter the top-layer perovskite sub-cell 10 again, rather than directly entering the bottom-layer crystalline-silicon sub-cell 20. The top-layer perovskite sub-cell 10 can perform secondary absorption to the at least some of the target light rays that are reflected and enter it, so as to increase the absorption of the target light rays by the top-layer perovskite sub-cell 10, which prevents that the target light rays directly enter the bottom-layer crystalline-silicon sub-cell 20 having a low energy utilization ratio of the target light rays within the short-wave wave band, thereby increasing the efficiency of the tandem solar cell.

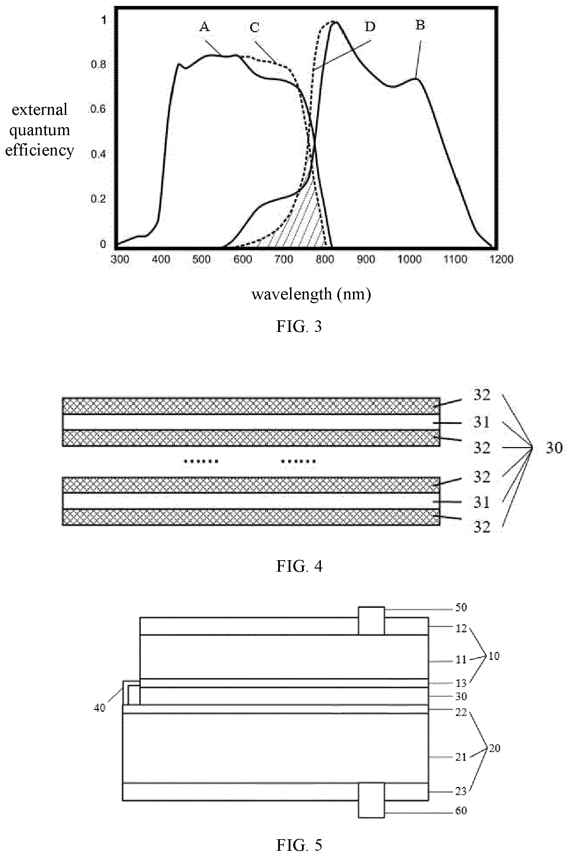

FIG. 3 shows a schematic diagram of the external quantum efficiency of another tandem solar cell according to an embodiment of the present application. Referring to FIG. 3, the curve C is a curve of the variation of the EQE of the top-layer perovskite sub-cell 10 with the wavelength in the case in which the tandem solar cell is provided with the optical regulating layer 30, and the curve D is a curve of the variation of the EQE of the bottom-layer crystalline-silicon sub-cell 20 with the wavelength in the case in which the tandem solar cell is provided with the optical regulating layer 30. In FIG. 3, the overlapping part of the curve C and the curve D has an area less than that of the overlapping part of the curve A and the curve B, the curve C deviates leftwardly as compared with the curve A, and the curve D deviates leftwardly as compared with the curve B. Because the energy densities of the light rays within the wave band of 600-800 nanometers progressively decrease with the increasing of the wavelengths, as compared with the case in which the optical regulating layer 30 is not provided, the top-layer perovskite sub-cell 10 in the tandem solar cell provided with the optical regulating layer 30 has an increased absorptivity or utilization ratio to the light rays of higher energy densities, and, moreover, some of the light rays of lower energy densities are utilized by the bottom-layer crystalline-silicon sub-cell 20 at the bottom layer. Which can, while ensuring the electric-current adaptation of the sub-cells in the tandem solar cell, increase the utilization ratio of the overall spectral energy by the tandem solar cell, and increase the limit of the overall efficiency of the tandem solar cell, and can maximize the photoelectric conversion efficiency of the tandem solar cell without increasing the thickness of the perovskite material in the top-layer perovskite sub-cell 10.

In the embodiments of the present application, the tandem solar cell includes: a top-layer perovskite sub-cell and a bottom-layer crystalline-silicon sub-cell, and an optical regulating layer provided between the top-layer perovskite sub-cell and the bottom-layer crystalline-silicon sub-cell; the top-layer perovskite sub-cell is provided at the light facing surface of the tandem solar cell, the bottom-layer crystalline-silicon sub-cell is provided at the shadow surface of the tandem solar cell, and the top-layer perovskite sub-cell and the bottom-layer crystalline-silicon sub-cell are electrically connected to each other; and the optical regulating layer is for reflecting at least some of the target light rays that pass through the top-layer perovskite sub-cell among the sunlight rays back into the top-layer perovskite sub-cell, and the target light rays refer to the light rays whose wavelengths are in the range of 600-800 nanometers among the sunlight rays. In the present application, the top-layer perovskite sub-cell cannot completely absorb the target light rays whose wavelengths are within the short-wave wave band in the range of 600-800 nanometers among the sunlight rays. After the part of the target light rays that are not absorbed by the top-layer perovskite sub-cell have passed through the perovskite sub-cell, because the optical regulating layer provided between the top-layer perovskite sub-cell and the bottom-layer crystalline-silicon sub-cell is for reflecting at least some of the target light rays back into the top-layer perovskite sub-cell, at least some of the target light rays within the short-wave wave band are reflected by the optical regulating layer and enter the top-layer perovskite sub-cell again, for the top-layer perovskite sub-cell to perform secondary absorption to the target light rays within the short-wave wave band, which prevents that the some of the target light rays within the short-wave wave band directly enter the bottom-layer crystalline-silicon sub-cell having a low utilization ratio of the target light rays within the short-wave wave band, thereby increasing the efficiency of the tandem solar cell.

Optionally, the maximum value of the reflectivity to the target light rays of the optical regulating layer 30 may be greater than or equal to a preset reflectivity. In other words, it is ensured that the optical regulating layer 30 has a certain reflectivity to at least some of the target light rays in the range of 600-800 nanometers, so that the optical regulating layer 30 can realize reflecting at least some of the target light rays that pass through the top-layer perovskite sub-cell 10 back into the top-layer perovskite sub-cell 10.

Optionally, the preset reflectivity may be a reflectivity of the optical regulating layer 30 that is preset with respect to the target light rays whose wavelengths are in the range of 600-800 nanometers among the sunlight rays, to ensure that at least some of the target light rays penetrating the top-layer perovskite sub-cell 10 are reflected and enter the top-layer perovskite sub-cell 10 again, so that the top-layer perovskite sub-cell 10 can perform secondary absorption to the target light rays in the range of 600-800 nanometers, thereby increasing the utilization ratio and the absorptivity of the top-layer perovskite sub-cell 10 to the target light rays. For example, the preset reflectivity may be 40%; in other words, the maximum value of the reflectivity to the target light rays of the optical regulating layer 30 is greater than or equal to 40%. For example, the reflectivity to the light rays of the wavelength of 700 nanometers is 50%, the reflectivity to the light rays of the wavelength of 650 nanometers is 20%, and the reflectivity to the light rays of the wavelength of 750 nanometers is 10%.

Optionally, the reflectivities to all of the target light rays among the sunlight rays of the optical regulating layer 30 are greater than or equal to the preset reflectivity. For example, if the preset reflectivity is 50%, for the light rays of any wavelength in the range of 600-800 nanometers, the optical regulating layer 30 can reflect at least a half of the light rays to the top-layer perovskite sub-cell 10.

Optionally, the average reflectivity to the target light rays among the sunlight rays of the optical regulating layer 30 is greater than or equal to the preset reflectivity.

Optionally, the preset reflectivity may be 30%-100%.

Optionally, the preset reflectivity may be 50±10%.

Optionally, FIG. 4 shows a schematic structural diagram of an optical regulating layer according to an embodiment of the present application. Referring to FIG. 4, the optical regulating layer 30 may include at least one low-refractive-index layer 31 and at least one high-refractive-index layer 32. The at least one low-refractive-index layer 31 and the at least one high-refractive-index layer 32 are separate.

Based on optics theories, the high-refractive-index layers 32 of higher refractive indexes and the low-refractive-index layers 31 of lower refractive indexes may be sequentially overlaid, to configure and construct the optical regulating layer 30 with the structure shown in FIG. 4. Furthermore, the optical regulating layer 30 having a specific reflectivity to the light rays of a specific wavelength may be constructed by regulating the parameters such as the refractive index of the high-refractive-index material contained in the high-refractive-index layer 32, the refractive index of the low-refractive-index material contained in the low-refractive-index layer 31, the thicknesses of the high-refractive-index layer 32 and the low-refractive-index layer 31, and the quantity of the overlaid layers.

Optionally, the low-refractive-index layer 31 in the optical regulating layer 30 may be a low-refractive-index material whose refractive index is less than or equal to a first preset refractive index, and the high-refractive-index layer 32 may be a high-refractive-index material whose refractive index is greater than or equal to a second preset refractive index, and the first preset refractive index is less than or equal to the second preset refractive index. In other words, the refractive index of the low-refractive-index material forming the low-refractive-index layer 31 is less than the refractive index of the high-refractive-index material forming the high-refractive-index layer 32.

In the embodiments of the present application, regarding the optical regulating layer 30 of a multilayer structure including at least one low-refractive-index layer 31 and at least one high-refractive-index layer 32, when an incident light of a wavelength of $\lambda$ enters the optical regulating layer 30 of a multilayer structure with an incident angle $\Phi_0$, according to the Fresnel equation for multilayer optical structures, the following formulas can be established:

$$\begin{bmatrix} A & B \\ C & D \end{bmatrix} = \begin{bmatrix} cos\delta_1 & i\left(\frac{1}{\omega_1}\right)sin\delta_1 \\ i\omega_1 sin\delta_1 & cos\delta_1 \end{bmatrix} \begin{bmatrix} cos\delta_2 & i\left(\frac{1}{\omega_2}\right)sin\delta_2 \\ i\omega_2 sin\delta_2 & cos\delta_2 \end{bmatrix} \cdots \begin{bmatrix} cos\delta_m & i\left(\frac{1}{\omega_n}\right)sin\delta_m \\ i\omega_m sin\delta_m & cos\delta_m \end{bmatrix} \tag{1}$$

$$\delta_i = \frac{2\pi}{\lambda} n_i cos\phi_i \tag{2}$$

$$\omega_i = n_i cos\phi_i \tag{3}$$

$$R = \left| \frac{\omega_0 A + \omega_0 \omega_g B - C - \omega_g D}{\omega_0 A + \omega_0 \omega_g B + C + \omega_g D} \right|^2 \tag{4}$$

where

$\lambda$ represents the wavelength of the incident light;

$\varphi_i$ represents the incident angle of the incident light at the i-th layer component of the optical regulating layer;

m represents the quantity of the low-refractive-index layers and the high-refractive-index layers in the optical regulating layer;

$n_i$ represents the refractive index of the i-th layer component in the optical regulating layer;

$\delta_i$ represents the phase difference of the reflected light wave at the i-th layer component in the optical regulating layer;

$\omega_i$ represents the angular component of the refractive index of the i-th layer component in the optical regulating layer in the horizontal direction;

$\omega_0$ represents the angular component of the refractive index of the incidence structure corresponding to the optical regulating layer in the horizontal direction;

$\omega_g$ represents the angular component of the refractive index of the substrate component corresponding to the optical regulating layer in the horizontal direction; and

R represents the reflectivity of the optical regulating layer.

Particularly, when an incident light of a wavelength of $\lambda$ enters the optical regulating layer 30 including m layers with an incident angle $\Phi_0$, the process may include, firstly, according to the incident angle $\Phi_0$, determining $\varphi_i$ representing the incident angle of the incident light at the i-th layer component in the optical regulating layer 30, substituting $\lambda$, $n_i$ and $\varphi_i$ into the formula (2) to calculate $\delta_i$, and substituting n; and $\varphi_i$ into the formula (3) to calculate $\omega_i$; subsequently substituting the calculated $\delta$; and $\omega_i$ into the formula (1), to determine the values of A, B, C and D in the matrix; and, finally, substituting A, B, C, D, $\omega_0$ and $\omega_g$ into the formula (4), whereby the reflectivity R of the optical regulating layer 30 of an m-layer structure to the incident light of the wavelength of $\lambda$ can be determined.

Correspondingly, according to the above calculation process, after the wavelength of the incident light for the optical regulating layer 30 and the reflectivity of the optical regulating layer 30 to the incident light are determined, the multi-layer structure of the optical regulating layer 30 may be reversely calculated and configured, to determine the quantities of the low-refractive-index layer and the high-refractive-index layer included by the optical regulating layer 30 and the refractive indexes of the low-refractive-index layer and the high-refractive-index layer. Further, after the refractive index of the low-refractive-index layer is determined, the refractive index corresponding to the low-refractive-index material included by the low-refractive-index layer and the thickness of the low-refractive-index layer may be determined according to the refractive index of the low-refractive-index layer, so that the low-refractive-index layer formed by the low-refractive-index material of that thickness has the corresponding refractive index. Likewise, after the refractive index of the high-refractive-index layer is determined, the refractive index corresponding to the high-refractive-index material included by the high-refractive-index layer and the thickness of the high-refractive-index layer may be determined according to the refractive index of the high-refractive-index layer, so that the high-refractive-index layer formed by the high-refractive-index material of that thickness has the corresponding refractive index.

Therefore, in the embodiments of the present application, because the maximum value of the reflectivity of the optical regulating layer 30 with respect to the target light rays in the range of 600-800 nanometers is required to be greater than or equal to the preset reflectivity, according to the wavelength range of 600-800 nanometers and the preset reflectivity, the refractive indexes corresponding to the low-refractive-index material and the high-refractive-index material in the optical regulating layer 30 can be determined, i.e., determining the categories of the low-refractive-index material and the high-refractive-index material, and the thicknesses of the low-refractive-index layer and the high-refractive-index layer and the quantities of the low-refractive-index layer and the high-refractive-index layer can be determined.

Optionally, the refractive index of the low-refractive-index layer 31 may be less than or equal to 1.5, and the refractive index of the high-refractive-index layer 32 may be greater than or equal to 1.9.

It should be noted that, if both of the quantities of the low-refractive-index layer 31 and the high-refractive-index layer 32 are 1, one low-refractive-index layer 31 whose refractive index is less than or equal to 1.5 and one high-refractive-index layer 32 whose refractive index is greater than or equal to 1.9 together form the optical regulating layer 30. However, in the case of a multilayer structure, a plurality of neighboring regulating layers all of the refractive indexes of which are less than or equal to 1.5 may be deemed as one low-refractive-index layer 31, a plurality of neighboring regulating layers all of the refractive indexes of which are greater than or equal to 1.9 may be deemed as one high-refractive-index layer 32, and, accordingly, according to the above calculation process, the reflectivity of the optical regulating layer 30 of the multilayer structure to the target light rays whose wavelengths are in the range of 600-800 nanometers is determined.

After the refractive indexes of the low-refractive-index layer 31 and the high-refractive-index layer 32 are determined, the thickness of the low-refractive-index layer 31 may be determined according to the refractive index of the low-refractive-index material included by the low-refractive-index layer 31, so that the low-refractive-index layer 31 formed by the low-refractive-index material of that thickness has the corresponding refractive index to the target light rays whose wavelengths are in the range of 600-800 nanometers. The thickness of the high-refractive-index layer 32 may be determined according to the refractive index of the high-refractive-index material included by the high-refractive-index layer 32, so that the high-refractive-index layer 32 formed by the high-refractive-index material of that thickness has the corresponding refractive index to the target light rays whose wavelengths are in the range of 600-800 nanometers.

Optionally, the low-refractive-index material forming the low-refractive-index layer 31 may include at least one of silicon oxide, silicon oxynitride, sodium fluoride, lithium fluoride, magnesium fluoride, calcium fluoride, sprio-OMe TAD and a fullerene derivative (PCBM), and the high-refractive-index material forming the high-refractive-index layer 32 may include at least one of carbon-60 (C60), diamond, titanium oxide, molybdenum oxide, tungsten oxide, vanadium oxide, zinc oxide, aluminum nitride, zirconium oxide, silicon nitride, silicon oxynitride, aluminum oxynitride, tungsten sulfide, molybdenum sulfide, lead sulfide, boron carbide, silicon carbide, bismuth ferrite, lead iodide, titanium nitride, vanadium nitride, boron phosphide, gallium phosphide, indium phosphide, phosphor germanium zinc, aluminum antimonide, gallium antimonide, indium antimonide, bismuth selenide, molybdenum selenide, lead selenide, tungsten selenide, zinc telluride, lead telluride and molybdenum telluride.

Optionally, referring to FIG. 1, the top-layer perovskite sub-cell 10 may include a perovskite light absorbing layer 11, a first charge-carrier transporting layer 12, a second charge-carrier transporting layer 13 and a first electrode 50, and the bottom-layer crystalline-silicon sub-cell 20 may include a crystalline-silicon light absorbing layer 21, a third charge-carrier transporting layer 22, a fourth charge-carrier transporting layer 23 and a second electrode 60.

The first charge-carrier transporting layer 12 is provided at the light facing surface of the perovskite light absorbing layer 11, the second charge-carrier transporting layer 13 is provided at the shadow surface of the perovskite light absorbing layer 11, the charge-carrier selectivity corresponding to the first charge-carrier transporting layer 12 and the charge-carrier selectivity corresponding to the second charge-carrier transporting layer 13 are opposite, and the first electrode 50 is provided on one side of the light facing surface of the perovskite light absorbing layer 11. The third charge-carrier transporting layer 22 is provided at the light facing surface of the crystalline-silicon light absorbing layer 21, the fourth charge-carrier transporting layer 23 is provided at the shadow surface of the crystalline-silicon light absorbing layer 21, the charge-carrier selectivity corresponding to the third charge-carrier transporting layer 22 and the charge-carrier selectivity corresponding to the fourth charge-carrier transporting layer 23 are opposite, and the second electrode 60 is provided on one side of the shadow surface of the crystalline-silicon light absorbing layer 21. The charge-carrier selectivity corresponding to the second charge-carrier transporting layer 13 and the charge-carrier selectivity corresponding to the third charge-carrier transporting layer 22 are opposite.

Particularly, when the sunlight rays are irradiating the tandem solar cell, the perovskite light absorbing layer 11 can absorb the light rays within the short-wave wave band among the sunlight rays, and the target light rays whose wavelengths are in the range of 600-800 nanometers that are reflected by the optical regulating layer 30 and enter, to generate charge carriers (electrons and holes) in the perovskite light absorbing layer 11. Further, the first charge-carrier transporting layer 12 is provided at the light facing surface of the perovskite light absorbing layer 11, the second charge-carrier transporting layer 13 is provided at the shadow surface of the perovskite light absorbing layer 11, and the charge-carrier selectivity corresponding to the first charge-carrier transporting layer 12 and the charge-carrier selectivity corresponding to the second charge-carrier transporting layer 13 are opposite. The first charge-carrier transporting layer 12 and the second charge-carrier transporting layer 13 can separate and transport the charge carriers generated in the perovskite light absorbing layer 11, to generate the photo-generated currents. Moreover, the crystalline-silicon light absorbing layer 21 can absorb the light rays within the long-wave wave band among the sunlight rays, to generate charge carriers (electrons and holes) in the crystalline-silicon light absorbing layer 21. Further, the third charge-carrier transporting layer 22 is provided at the light facing surface of the crystalline-silicon light absorbing layer 21, the fourth charge-carrier transporting layer 23 is provided at the shadow surface of the crystalline-silicon light absorbing layer 21, and the charge-carrier selectivity corresponding to the third charge-carrier transporting layer 22 and the charge-carrier selectivity corresponding to the fourth charge-carrier transporting layer 23 are opposite. The third charge-carrier transporting layer 22 and the fourth charge-carrier transporting layer 23 can separate and transport the charge carriers generated in the crystalline-silicon light absorbing layer 21, to generate the photo-generated currents. Moreover, because the charge-carrier selectivity corresponding to the second charge-carrier transporting layer 13 and the charge-carrier selectivity corresponding to the third charge-carrier transporting layer 22 are opposite, the top-layer perovskite sub-cell 10 and the bottom-layer crystalline-silicon sub-cell 20 can be connected in series, so that the photo-generated currents generated by the sub-cells individually can be further converged, and subsequently collected by the first electrode 50 provided on one side of the light facing surface of the perovskite light absorbing layer 11 and the second electrode 60 provided on one side of the shadow surface of the crystalline-silicon light absorbing layer 21, thereby realizing the separation of the charge carriers in the tandem solar cell, to complete the convergence of the photo-generated currents in the sub-cells, to supply electric energy to the external device.

It should be noted that, in the case in which the top-layer perovskite sub-cell 10 includes the perovskite light absorbing layer 11, the first charge-carrier transporting layer 12 and the second charge-carrier transporting layer 13 and the bottom-layer crystalline-silicon sub-cell 20 includes the crystalline-silicon light absorbing layer 21, the third charge-carrier transporting layer 22 and the fourth charge-carrier transporting layer 23, when the reflectivity R of the optical regulating layer 30 of the multi-layer structure is being calculated by using the formulas (1)-(4), it may be considered that all of the layer components between the perovskite light absorbing layer 11 and the crystalline-silicon light absorbing layer 21 together form the optical regulating layer 30; in other words, the second charge-carrier transporting layer 13 and the third charge-carrier transporting layer 22 may be considered also part of the optical regulating layer 30.

Because the second charge-carrier transporting layer 13 and the third charge-carrier transporting layer 22 are commonly used materials, and have particular thicknesses and material refractive indexes, the refractive indexes corresponding to the second charge-carrier transporting layer 13 and the third charge-carrier transporting layer 22 may be considered as constant quantities, and accordingly those constant quantities may be substituted into the formulas (1)-(4) to calculate the reflectivity R of the optical regulating layer 30 in which the first layer is the second charge-carrier transporting layer 13 and the last layer is the third charge-carrier transporting layer 22.

Correspondingly, the incidence structure corresponding to the optical regulating layer 30 is the perovskite light absorbing layer 11, and the substrate component corresponding to the optical regulating layer 30 is the crystalline-silicon light absorbing layer 21. In other words, $\omega_0$ is the angular component of the refractive index of the perovskite light absorbing layer 11 in the horizontal direction, and $\omega_g$ is the angular component of the refractive index of the crystalline-silicon light absorbing layer 21 in the horizontal direction. In addition, if a crystalline-silicon or amorphous-silicon layer exists between the perovskite light absorbing layer 11 and the crystalline-silicon light absorbing layer 21, the crystalline-silicon or amorphous-silicon layer may be used as the substrate component corresponding to the optical regulating layer 30, to simplify the calculation. The practical calculation may be performed by using corresponding simulated calculation software or program code as assistance.

Optionally, referring to FIG. 1, the second charge-carrier transporting layer 13 in the top-layer perovskite sub-cell 10 and the third charge-carrier transporting layer 22 in the bottom-layer crystalline-silicon sub-cell 20 are electrically connected to each other, to realize the electric connection between the top-layer perovskite sub-cell 10 and the bottom-layer crystalline-silicon sub-cell 20, thereby realizing the convergence of the photo-generated currents in the sub-cells.

Optionally, referring to FIG. 1, the tandem solar cell may further include an electrically conducting component 40. In other words, the second charge-carrier transporting layer 13 in the top-layer perovskite sub-cell 10 and the third charge-carrier transporting layer 22 in the bottom-layer crystalline-silicon sub-cell 20 may realize the electric connection therebetween by the electrically conducting component 40.

Optionally, the electrically conducting component 40 may include at least one of a transparent electrically conductive material, a metal material and a mixed material containing multiple types of metals, and the transparent electrically conductive material may include at least one of indium tin oxide (ITO) and aluminum-doped zinc oxide (AZO).

Optionally, a through hole or slot component penetrating the optical regulating layer 30 may be provided in the optical regulating layer 30. The electrically conducting component 40 is provided in the through hole or slot component of the optical regulating layer 30, whereby one end of the electrically conducting component 40 is connected to the second charge-carrier transporting layer 13 of the top-layer perovskite sub-cell 10, and the other end of the electrically conducting component 40 is connected to the third charge-carrier transporting layer 22 of the bottom-layer crystalline-silicon sub-cell 20, thereby ensuring that the second charge-carrier transporting layer 13 in the top-layer perovskite sub-cell 10 and the third charge-carrier transporting layer 22 in the bottom-layer crystalline-silicon sub-cell 20 can realize the electric connection therebetween by the electrically conducting component 40.

Optionally, the ratio of the area of the projection on the light facing surface of the through hole or slot component provided in the optical regulating layer 30 to the area of the projection of the optical regulating layer 30 on the light facing surface is less than 20%. In other words, it is prevented that the through hole or slot component having a high area is provided in the optical regulating layer 30 to fabricate the electrically conducting component 40, which causes that the optical regulating layer 30 has a low area that is used to reflect the target light rays whose wavelengths are in the range of 600-800 nanometers, and therefore a low quantity of the target light rays whose wavelengths are in the range of 600-800 nanometers are reflected and enter the top-layer perovskite sub-cell 10 to perform secondary absorption.

Optionally, FIG. 5 shows a schematic structural diagram of a second type of the tandem solar cell according to an embodiment of the present application. Referring to FIG. 5, the electrically conducting component 40 may be provided at a component side position of the tandem solar cell. One end of the electrically conducting component 40 is connected to the second charge-carrier transporting layer 13, and the other end of the electrically conducting component 40 is connected to the third charge-carrier transporting layer 22. In other words, the electrically conducting component 40 is provided independently outside the tandem solar cell, thereby avoiding changing the structure of the optical regulating layer 30.

In the embodiments of the present application, if the tandem solar cell includes a plurality of independent subunits, then the plurality of independent subunits may be connected in parallel to each other, and subsequently connected to the top-layer perovskite sub-cell 10 and the bottom-layer crystalline-silicon sub-cell 20 in the tandem solar cell by the electrically conducting component 40 provided at the component side position of the tandem solar cell.

Optionally, the optical regulating layer 30 may contain an electrically conductive material. Accordingly, the optical regulating layer 30 can have the capacity of conducting the top-layer perovskite sub-cell 10 and the bottom-layer crystalline-silicon sub-cell 20.

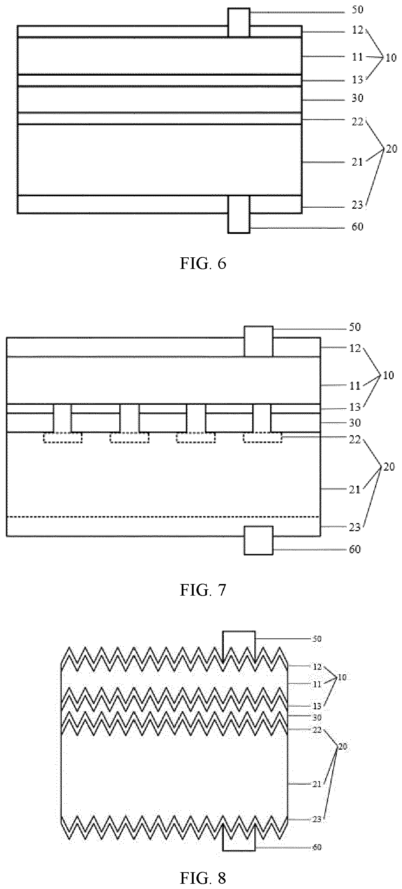

FIG. 6 shows a schematic structural diagram of a third type of the tandem solar cell according to an embodiment of the present application. Referring to FIG. 6, because the optical regulating layer 30 can have the capacity of conducting the top-layer perovskite sub-cell 10 and the bottom-layer crystalline-silicon sub-cell 20, the second charge-carrier transporting layer 13 in the top-layer perovskite sub-cell 10 and the third charge-carrier transporting layer 22 in the bottom-layer crystalline-silicon sub-cell 20 can be electrically connected to each other directly by the optical regulating layer 30, and it is not required to provide the electrically conducting component 40.

Optionally, the tandem solar cell may further include a first passivation layer, a first anti-reflection layer and a second passivation layer.

The first passivation layer is provided between the first charge-carrier transporting layer 12 and the perovskite light absorbing layer 11, and the first anti-reflection layer is provided at the surface of the first charge-carrier transporting layer 12 that is close to the perovskite light absorbing layer 11. In other words, the first charge-carrier transporting layer 12, the first passivation layer and the first anti-reflection layer located at the light facing surface of the perovskite light absorbing layer 11 can together form a functional layer of a multilayer structure, the functional layer has the functions such as interface passivation, selective contacting and transportation of the charge carriers, and upper-surface antireflection. The second passivation layer is provided between the second charge-carrier transporting layer 13 and the perovskite light absorbing layer 11. In other words, the second charge-carrier transporting layer 13 and the second passivation layer located at the shadow surface of the perovskite light absorbing layer 11 can together form a functional layer of a multilayer structure, and the functional layer has the functions of interface passivation and selective contacting and transportation of the charge carriers. Furthermore, the charge-carrier selectivity corresponding to the first charge-carrier transporting layer 12 and the charge-carrier selectivity corresponding to the second charge-carrier transporting layer 13 are opposite; in other words, the charge carriers corresponding to the functions of selective contacting and transportation of the charge carriers of the first charge-carrier transporting layer 12 and the second charge-carrier transporting layer 13 are opposite.

Optionally, the tandem solar cell may further include a third passivation layer, a fourth passivation layer and a second anti-reflection layer.

The third passivation layer is provided between the third charge-carrier transporting layer 22 and the crystalline-silicon light absorbing layer 21. In other words, the third charge-carrier transporting layer 22 and the third passivation layer located at the light facing surface of the crystalline-silicon light absorbing layer 21 can together form a functional layer of a multilayer structure, and the functional layer has the functions of interface passivation and selective contacting and transportation of the charge carriers. The fourth passivation layer is provided between the fourth charge-carrier transporting layer 23 and the crystalline-silicon light absorbing layer 21, and the second anti-reflection layer is provided at the surface of the fourth charge-carrier transporting layer 23 that is close to the crystalline-silicon light absorbing layer 21. In other words, the fourth charge-carrier transporting layer 23, the fourth passivation layer and the second anti-reflection layer located at the shadow surface of the crystalline-silicon light absorbing layer 21 can together form a functional layer of a multilayer structure, and the functional layer has the functions such as interface passivation, selective contacting and transportation of the charge carriers, and lower-surface antireflection. Furthermore, the charge-carrier selectivity corresponding to the third charge-carrier transporting layer 22 and the charge-carrier selectivity corresponding to the fourth charge-carrier transporting layer 23 are opposite; in other words, the charge carriers corresponding to the functions of selective contacting and transportation of the charge carriers of the third charge-carrier transporting layer 22 and the fourth charge-carrier transporting layer 23 are opposite.

Optionally, FIG. 7 shows a schematic structural diagram of a fourth type of the tandem solar cell according to an embodiment of the present application. Referring to FIG. 7, one end of the first electrode 50 of the top-layer perovskite sub-cell 10 is provided at the light facing surface of the perovskite light absorbing layer 11, or provided at the light facing surface of the first charge-carrier transporting layer 12, or provided inside the first charge-carrier transporting layer 12, and the other end of the first electrode 50 passes through the first charge-carrier transporting layer 12 and protrudes out of the surface of the first charge-carrier transporting layer 12 that is away from the perovskite light absorbing layer 11. In other words, the first electrode 50 may partially or entirely penetrate the first charge-carrier transporting layer 12.

One end of the second electrode 60 is provided at the shadow surface of the crystalline-silicon light absorbing layer 21, or provided at the shadow surface of the fourth charge-carrier transporting layer 23, or provided inside the fourth charge-carrier transporting layer 23, and the other end of the second electrode 60 passes through the fourth charge-carrier transporting layer 23 and protrudes out of the surface of the fourth charge-carrier transporting layer 23 that is away from the crystalline-silicon light absorbing layer 21. In other words, the first electrode 50 may partially or entirely penetrate the first charge-carrier transporting layer 12.

Optionally, the third charge-carrier transporting layer 22 and the fourth charge-carrier transporting layer 23 provided on the two sides of the crystalline-silicon light absorbing layer 21 may be charge-carrier transporting layers that are obtained by performing in-situ doping (local in-situ doping or full in-situ doping) at the light facing surface and the shadow surface of the crystalline-silicon light absorbing layer 21 respectively.

In the embodiments of the present application, simultaneously with the local in-situ doping or full in-situ doping at the shadow surface of the crystalline-silicon light absorbing layer 21 to obtain the fourth charge-carrier transporting layer 23, the structures of surface passivation and antireflection may be integrated, thereby forming an emitter passivation and back-face contacting (PERC) structure, an emitter passivation and back-face local diffusion (PERT) structure or an emitter passivation back-face local diffusion (PERL) structure.

Optionally, FIG. 8 shows a schematic structural diagram of a fifth type of the tandem solar cell according to an embodiment of the present application. Referring to FIG. 8, both of the light facing surface and the shadow surface of the crystalline-silicon light absorbing layer 21 may have a suede structure, to increase the light trapping of the tandem solar cell, and increase the light absorption of the solar cell. The shapes of the other structural layers of the crystalline-silicon light absorbing layer 21 are configured by adapting for the suede structure of the crystalline-silicon light absorbing layer 21.

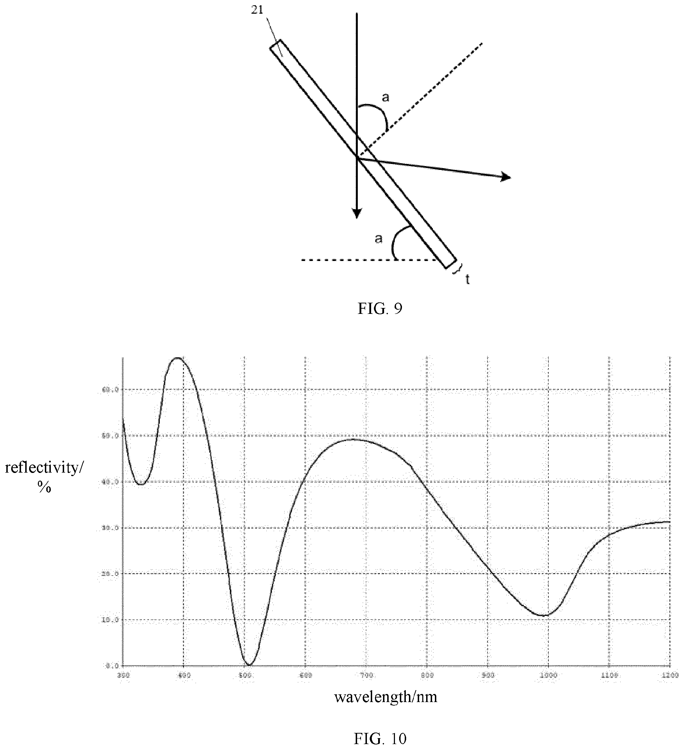

In an embodiment of the present application, FIG. 9 shows a schematic diagram of the reflection of a suede structure of a crystalline-silicon light absorbing layer according to an embodiment of the present application. Referring to FIG. 9, because the average thickness t of the crystalline-silicon light absorbing layer 21 in the bottom-layer crystalline-silicon sub-cell 20 is of the micrometer order, and the thicknesses of the layer components of its upper layer, as compared with the height of the suede structure at the surface the crystalline-silicon light absorbing layer 21, are at the approximate order of magnitude, the state of the internal reflection of the crystalline-silicon light absorbing layer 21 is considered as follows: the incident light enters perpendicular to the macroscopic plane of the cell, and forms an incident angle of $a$ with the bevel surface of the pyramid suede structure at the surface of the crystalline-silicon light absorbing layer 21, and regarding monocrystalline silicon, $a$ is usually 49°. The reflection of the incident light can increase the length of the optical path of the light rays in the crystalline-silicon light absorbing layer 21, to serve for light trapping to the incident light, which can increase the utilization ratio of the incident light by the bottom-layer crystalline-silicon sub-cell 20, thereby increasing the efficiency of the tandem solar cell.

In an embodiment of the present application, the top-layer perovskite sub-cell 10 of the tandem solar cell is a wide-band-gap perovskite cell, and the band gap width is 1.4-1.9 electron volts. The bottom-layer crystalline-silicon sub-cell 20 may be a homojunction or heterojunction device. The crystalline-silicon light absorbing layer 21 may be an N-type or P-type silicon wafer, and a single-crystal or polycrystalline silicon wafer. The upper and lower surfaces may be a flat face, be a suede or have a nano-sized light trapping structure, and may or may not include p-n junctions. The electrically conducting component 40 employs an electrically conductive material, may be a transparent electrically conductive semiconductor material such as ITO and AZO, and may also be a metal material, a mixed material of multiple types of metals, and so on.

The structure of the tandem solar cell according to the embodiments of the present application will be described below with reference to the particular examples.

Example 1:

The structure of the tandem solar cell is shown in FIG. 1. The top-layer perovskite sub-cell 10 is a wide-band-gap perovskite cell, and the perovskite light absorbing layer 11 employs $CH_3NH_3PbI_3$, with the thickness of 300-800 nanometers, preferably 300-500 nanometers. The first charge-carrier transporting layer 12 has a hole selectivity, and employs a stack of a Spiro-OMeTAD material and an ITO material, the Spiro-OMeTAD material has a thickness of 20 nanometers, and the ITO has a thickness of 60 nanometers. In addition, the top-layer perovskite sub-cell 10 may also include an anti-reflection layer having the function of upper-surface anti-reflection, and the anti-reflection layer employs the stacking material of magnesium fluoride and silicon nitride. The second charge-carrier transporting layer 13 has an electron selectivity, and employs a stack of a C60-PCBM material and an ITO material, and the C60-PCBM layer has a thickness of 30 nanometers, and the ITO has a thickness of 70 nanometers. The first electrode 50 is provided at the light facing surface of the perovskite light absorbing layer 11; in other words, one end of the first electrode 50 contacts the perovskite light absorbing layer 11, and the other end penetrates the first charge-carrier transporting layer 12 and protrudes out of the surface of the first charge-carrier transporting layer 12 that is away from the perovskite light absorbing layer 11. The first electrode 50 employs the metals silver, copper or aluminum, or multiple types of metal alloys.

Further, the bottom-layer crystalline-silicon sub-cell 20 is a homojunction crystalline-silicon cell. The crystalline-silicon light absorbing layer 21 employs a P-type silicon wafer. The third charge-carrier transporting layer 22 is provided at the upper surface of the crystalline-silicon light absorbing layer 21. The third charge-carrier transporting layer 22 has a hole selectivity, employs a P-type passivation contacting structure, and employs a stack of silicon oxide and P-type polycrystalline silicon. The optical regulating layer 30 is provided at the upper surface of the third charge-carrier transporting layer 22. The optical regulating layer 30 is tapped and provided with a series-connecting component 40 to realize the series connection between the upper sub-cell and the lower sub-cell. The fourth charge-carrier transporting layer 23 is provided at the lower surface of the crystalline-silicon light absorbing layer 21. The fourth charge-carrier transporting layer 23 has an electron selectivity, employs an N-type passivation contacting structure, and employs a stack of silicon oxide and N-type polycrystalline silicon. The bottom-layer crystalline-silicon sub-cell 20 may also include an anti-reflection layer having the function of lower-surface anti-reflection, and the anti-reflection layer employs a stack of silicon nitride and silicon oxynitride. The second electrode 60 is provided at the shadow surface of the crystalline-silicon light absorbing layer 21; in other words, one end of the second electrode 60 contacts the crystalline-silicon light absorbing layer 21, and the other end penetrates the fourth charge-carrier transporting layer 23 and protrudes out of the surface of the fourth charge-carrier transporting layer 23 that is away from the crystalline-silicon light absorbing layer 21.

The optical regulating layer 30 has a thickness of 281 nanometers, and is of a multi-layer structure. The optical regulating layer 30 of the multilayer structure includes a 6-nanometer-thick silicon nitride, a 25-nanometer-thick magnesium fluoride, a 150-nanometer-thick silicon nitride and a 100-nanometer-thick magnesium fluoride that are sequentially arranged upwardly from the surface of the third charge-carrier transporting layer 22. The layer components are fabricated by physical vapor deposition (sputtering) or chemical vapor deposition. The optical regulating layer 30 is provided with openings, which have hole diameters of 3-5 micrometers and hole spacings of 20-50 micrometers, and are distributed in an array. The area of the projections of the openings in the direction perpendicular to the incidence direction of the light rays does not exceed 80% of the area of the projection of the perovskite light absorbing layer 11. The openings are filled with series-connecting components 40 fabricated by using silver or a silver alloy material. The series-connecting components 40 extend throughout the optical regulating layer 30, and directly contact the second structural layer 13 and the third charge-carrier transporting layer 22, to realize the series connection of the top-layer perovskite sub-cell 10 and the bottom-layer crystalline-silicon sub-cell 20.

FIG. 10 shows a curve of the reflectivity of a first type of the optical regulating layer according to an embodiment of the present application, i.e., a curve of the variation of the reflectivity corresponding to the optical regulating layer 30 included by the tandem solar cell according to the present example with the wavelength of the incident light rays. Referring to FIG. 10, the reflectivity of the optical regulating layer 30 according to the present example to the light rays whose wavelengths are in the range of 600-780 nanometers is greater than 40%, which can realize a good optical-regulation function in the tandem solar cell.

Example 2:

The structure of the tandem solar cell is shown in FIG. 5. The top-layer perovskite sub-cell 10 is a wide-band-gap perovskite cell, and the perovskite light absorbing layer 11 employs mixed perovskite of $MAPbI_3$ and $FAPBI_3$, with the thickness of 300-800 nanometers, preferably 300-500 nanometers. The first charge-carrier transporting layer 12 has a hole selectivity, and employs a stack of a Spiro-OMeTAD material and an ITO material, the Spiro-OMeTAD material has a thickness of 20 nanometers, and the ITO has a thickness of 60 nanometers. In addition, the top-layer perovskite sub-cell 10 may also include an anti-reflection layer having the function of upper-surface anti-reflection, and the anti-reflection layer employs the stacking material of magnesium fluoride and silicon nitride. The second charge-carrier transporting layer 13 has an electron selectivity, and employs a stack of a C60 material and an ITO material, the C60 has a thickness of 20-30 nanometers, and the ITO has a thickness of 50 nanometers. In addition, the top-layer perovskite sub-cell 10 may also include a passivation layer having the function of passivation. The passivation layer employs calcium fluoride, and has a thickness of 2 nanometers. The passivation layer is provided between the perovskite light absorbing layer 11 and the electron selectively contacting and transferring component formed by the stack of the C60 material and the ITO material.

Further, the bottom-layer crystalline-silicon sub-cell 20 employs a heterojunction structure process. The crystalline-silicon light absorbing layer 21 employs an N-type silicon wafer. The third charge-carrier transporting layer 22 is provided at the upper surface of the crystalline-silicon light absorbing layer 21. The third charge-carrier transporting layer 22 has a hole selectivity, and employs a stack of intrinsic amorphous silicon and P-type amorphous silicon. The fourth charge-carrier transporting layer 23 is provided at the lower surface of the crystalline-silicon light absorbing layer 21. The fourth charge-carrier transporting layer 23 has an electron selectivity, and employs a stack of intrinsic amorphous silicon and N-type amorphous silicon. The bottom-layer crystalline-silicon sub-cell 20 may also include an anti-reflection layer having the function of lower-surface anti-reflection, and the anti-reflection layer employs the stacking material of silicon nitride.

The optical regulating layer 30 has a thickness of 315 nanometers, and is of a multilayer structure. The optical regulating layer 30 of the multilayer structure includes a 3-nanometer-thick silicon oxide, a 50-nanometer-thick magnesium fluoride, a 50-nanometer-thick titanium oxide, a 200-nanometer-thick magnesium fluoride and a 12-nanometer-thick titanium oxide that are sequentially arranged upwardly from the surface of the crystalline-silicon light absorbing layer 21. The layer components are fabricated by physical vapor deposition.

The area of the bottom-layer crystalline-silicon sub-cell 20 is slightly greater than the area of the top-layer perovskite sub-cell 10. The electrically conducting component 40 is provided at a side position of the top-layer perovskite sub-cell 10. The electrically conducting component 40 is fabricated by using a copper wire, one end is connected to the second charge-carrier transporting layer 13, and the other end is connected to the third charge-carrier transporting layer 22, to realize the series connection of the top-layer perovskite sub-cell 10 and the bottom-layer crystalline-silicon sub-cell 20.

In addition, the first electrode 50 is provided at the light facing surface of the perovskite light absorbing layer 11; in other words, one end of the first electrode 50 contacts the perovskite light absorbing layer 11, and the other end penetrates the first charge-carrier transporting layer 12 and protrudes out of the surface of the first charge-carrier transporting layer 12 that is away from the perovskite light absorbing layer 11. The second electrode 60 is provided at the shadow surface of the crystalline-silicon light absorbing layer 21; in other words, one end of the second electrode 60 contacts the crystalline-silicon light absorbing layer 21, and the other end penetrates the fourth charge-carrier transporting layer 23 and protrudes out of the surface of the fourth charge-carrier transporting layer 23 that is away from the crystalline-silicon light absorbing layer 21.

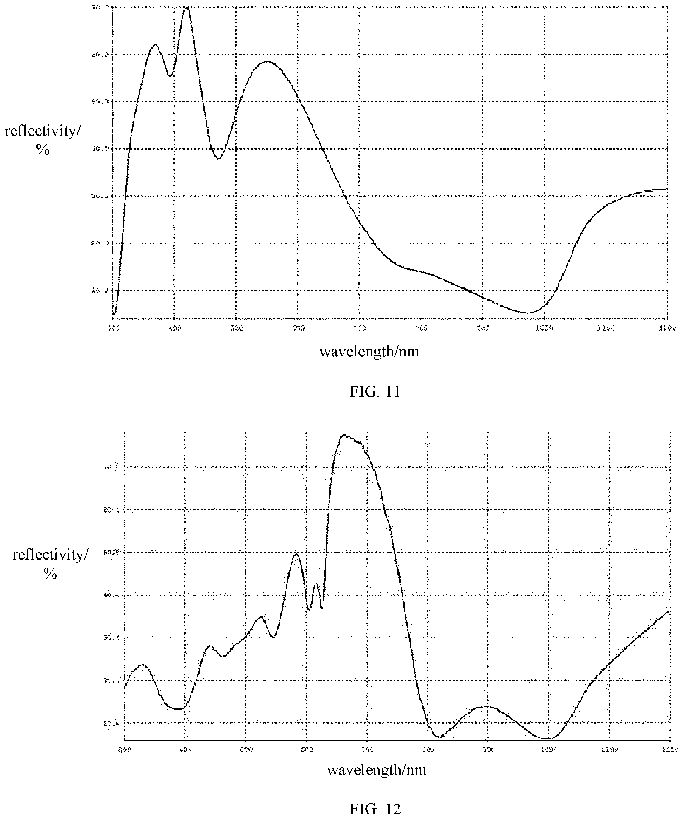

FIG. 11 shows a curve of the reflectivity of a second type of the optical regulating layer according to an embodiment of the present application, i.e., a curve of the variation of the reflectivity corresponding to the optical regulating layer 30 included by the tandem solar cell according to the present example with the wavelength of the incident light rays. Referring to FIG. 11, the reflectivity of the optical regulating layer 30 according to the present example to the light rays whose wavelengths are in the range of 600-640 nanometers is greater than 40%, which can realize a good optical-regulation function in the tandem solar cell.

Example 3:

The structure of the tandem solar cell is shown in FIG. 6. The top-layer perovskite sub-cell 10 is a wide-band-gap perovskite cell, and the perovskite light absorbing layer 11 employs an organic-inorganic hybrid perovskite material, with the thickness of 300-800 nanometers, preferably 300-500 nanometers. The first charge-carrier transporting layer 12 has an electron selectivity, employs the material of tin oxide, and has a thickness of 30 nanometers. In addition, the top-layer perovskite sub-cell 10 may also include an anti-reflection layer having the function of upper-surface anti-reflection, and the anti-reflection layer employs the stacking material of magnesium fluoride and aluminum oxide. The second charge-carrier transporting layer 13 has a hole selectivity, and employs a stack of the material of molybdenum oxide and ITO, the molybdenum oxide has a thickness of 20 nanometers, and the ITO has a thickness of 60 nanometers.

Further, the bottom-layer crystalline-silicon sub-cell 20 employs a mixed-type silicon solar cell. The crystalline-silicon light absorbing layer 21 employs an N-type silicon wafer. The lower surface of the crystalline-silicon light absorbing layer 21 may have a suede light-trapping structure, and the upper surface is a flat face. The third charge-carrier transporting layer 22 is provided at the upper surface of the crystalline-silicon light absorbing layer 21. The third charge-carrier transporting layer 22 has an electron selectivity, and employs a stack of PVD-deposited zinc oxide and aluminum-doped zinc oxide. The fourth charge-carrier transporting layer 23 is provided at the lower surface of the crystalline-silicon light absorbing layer 21. The fourth charge-carrier transporting layer 23 has a hole selectivity, and employs deposited intrinsic amorphous silicon, a P-type amorphous-silicon stack and an ITO material. The bottom-layer crystalline-silicon sub-cell 20 may also include an anti-reflection layer having the function of lower-surface anti-reflection, and the anti-reflection layer employs a silicon-nitride thin film.

The optical regulating layer 30 is provided at the upper surface of the third charge-carrier transporting layer 22. The optical regulating layer 30 is of a multilayer structure. The optical regulating layer 30 of the multilayer structure includes a 3-nanometer-thick silicon oxide, a 90-nanometer-thick magnesium fluoride, a 17-nanometer-thick tungsten sulfide, a 90-nanometer-thick magnesium fluoride, a 65-nanometer-thick tungsten sulfide, a 14-nanometer-thick magnesium fluoride and a 50-nanometer-thick tungsten sulfide that are sequentially arranged upwardly from the surface of the third charge-carrier transporting layer 22. The layer components are fabricated by physical vapor deposition. The optical regulating layer 30 is provided with grooves, which have groove widths of 5-10 micrometers and groove spacings of 50-100 micrometers, and are parallelly distributed in an array. The grooves are filled with series-connecting components 40 fabricated by using silver or a silver alloy material. The series-connecting components 40 extend throughout the optical regulating layer 30, and directly contact the second charge-carrier transporting layer 13 and the third charge-carrier transporting layer 22, to realize the series connection of the top-layer perovskite sub-cell 10 and the bottom-layer crystalline-silicon sub-cell 20.

In addition, the first electrode 50 is provided at the light facing surface of the perovskite light absorbing layer 11; in other words, one end of the first electrode 50 contacts the perovskite light absorbing layer 11, and the other end penetrates the first charge-carrier transporting layer 12 and protrudes out of the surface of the first charge-carrier transporting layer 12 that is away from the perovskite light absorbing layer 11. The second electrode 60 is provided at the shadow surface of the crystalline-silicon light absorbing layer 21; in other words, one end of the second electrode 60 contacts the crystalline-silicon light absorbing layer 21, and the other end penetrates the fourth charge-carrier transporting layer 23 and protrudes out of the surface of the fourth charge-carrier transporting layer 23 that is away from the crystalline-silicon light absorbing layer 21.

FIG. 12 shows a curve of the reflectivity of a third type of the optical regulating layer according to an embodiment of the present application, i.e., a curve of the variation of the reflectivity corresponding to the optical regulating layer 30 included by the tandem solar cell according to the present example with the wavelength of the incident light rays. Referring to FIG. 12, the reflectivity of the optical regulating layer 30 according to the present example to the light rays of the wavelength of 660 nanometers reaches the peak value of 77.7%, which can realize a good optical-regulation function in the tandem solar cell.

Example 4:

The structure of the tandem solar cell is shown in FIG. 8. The top-layer perovskite sub-cell 10 is a wide-band-gap perovskite cell, and the perovskite light absorbing layer 11 employs an organic-inorganic hybrid perovskite material, with the thickness of 300-800 nanometers, preferably 300-500 nanometers. The first charge-carrier transporting layer 12 has a hole selectivity, and employs a stack of the material of molybdenum oxide and an ITO material, the molybdenum oxide has a thickness of 20 nanometers, and the ITO has a thickness of 60 nanometers. In addition, the top-layer perovskite sub-cell 10 may also include an anti-reflection layer having the function of upper-surface anti-reflection, and the anti-reflection layer employs the stacking material of silicon oxynitride and magnesium fluoride. The second charge-carrier transporting layer 13 has an electron selectivity, and employs the stacking material of a C60 material and tin oxide, the C60 has a thickness of 20 nanometers, and the tin oxide has a thickness of 30 nanometers.

Further, the bottom-layer crystalline-silicon sub-cell 20 employs a crystalline-silicon-amorphous-silicon heterojunction solar cell. The crystalline-silicon light absorbing layer 21 employs an N-type silicon wafer. Both of the upper surface and the lower surface of the crystalline-silicon light absorbing layer 21 have a suede light-trapping structure. The deposited intrinsic amorphous silicon and the P-type amorphous silicon at the upper surface of the crystalline-silicon light absorbing layer 21 are stacked to form the third charge-carrier transporting layer 22. The third charge-carrier transporting layer 22 has a hole selectivity. The deposited intrinsic amorphous silicon, the N-type amorphous silicon and the ITO at the lower surface of the crystalline-silicon light absorbing layer 21 are stacked to form the fourth charge-carrier transporting layer 23. The fourth charge-carrier transporting layer 23 has an electron selectivity. In addition, the bottom-layer crystalline-silicon sub-cell 20 may also include an anti-reflection layer having the function of lower-surface anti-reflection, and the anti-reflection layer employs a stacking structure of a plurality of layers of silicon nitride.

The optical regulating layer 30 is provided at the upper surface of the third charge-carrier transporting layer 22. The optical regulating layer 30 employs the stacking material of PCBM and titanium oxide. Because the optical regulating layer 30 may contain an electrically conductive material, the optical regulating layer 30 can have the capacity of conducting the top-layer perovskite sub-cell 10 and the bottom-layer crystalline-silicon sub-cell 20, and, therefore, it is not required to provide the electrically conducting component 40 in the tandem solar cell. The optical regulating layer 30 is of a multilayer structure. The optical regulating layer 30 of the multilayer structure includes a 26-nanometer-thick PCBM, a 200-nanometer-thick titanium oxide and a 28-nanometer-thick PCBM that are sequentially arranged upwardly from the surface of the third charge-carrier transporting layer 22.

In addition, the first electrode 50 is provided at the light facing surface of the first charge-carrier transporting layer 12, and the second electrode 60 is provided at the shadow surface of the fourth charge-carrier transporting layer 23.

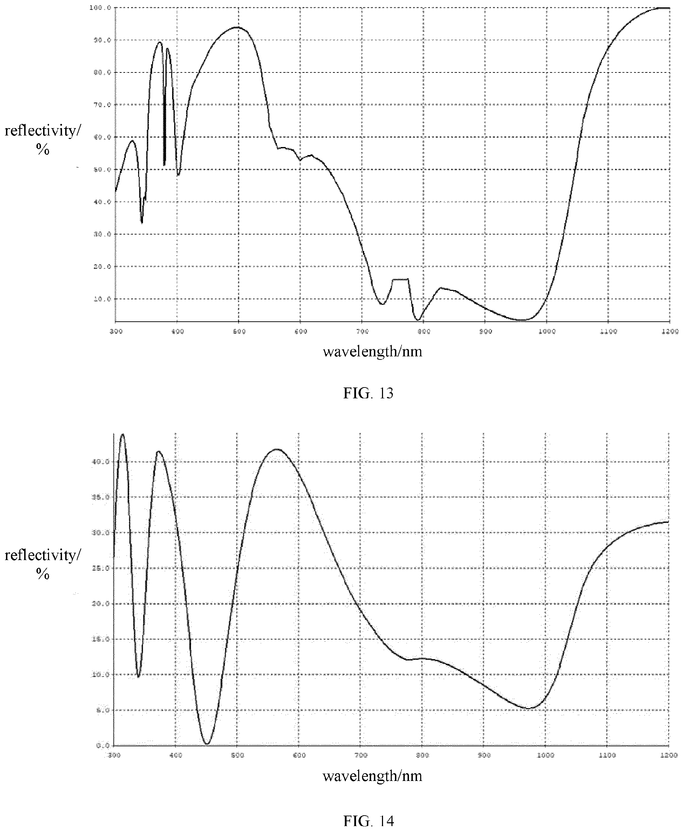

FIG. 13 shows a curve of the reflectivity of a fourth type of the optical regulating layer according to an embodiment of the present application, i.e., a curve of the variation of the reflectivity corresponding to the optical regulating layer 30 included by the tandem solar cell according to the present example with the wavelength of the incident light rays. Referring to FIG. 13, the reflectivity of the optical regulating layer 30 according to the present example to the light rays whose wavelengths are in the range of 600-670 nanometers is greater than 40%, which can realize a good optical-regulation function in the tandem solar cell.

Example 5:

The structure of the tandem solar cell is shown in FIG. 7. The top-layer perovskite sub-cell 10 is a wide-band-gap perovskite cell, and the perovskite light absorbing layer 11 employs $CH_3NH_3PbI_3$, with the thickness of 300-800 nanometers, preferably 300-500 nanometers. The first charge-carrier transporting layer 12 has an electron selectivity, and employs a stack of C60 and an ITO material, and the C60 has a thickness of 20 nanometers, and the ITO has a thickness of 60 nanometers. In addition, the top-layer perovskite sub-cell 10 may also include an anti-reflection layer having the function of upper-surface anti-reflection, and the anti-reflection layer employs the stacking material of magnesium fluoride and silicon nitride. The second charge-carrier transporting layer 13 has a hole selectivity, and employs a stack of a Spiro-OMeTAD material and an ITO material, the Spiro-OMeTAD material has a thickness of 20 nanometers, and the ITO has a thickness of 60 nanometers.

Further, the bottom-layer crystalline-silicon sub-cell 20 is a homojunction crystalline-silicon cell. The crystalline-silicon light absorbing layer 21 employs an N-type silicon wafer. The upper surface of the crystalline-silicon light absorbing layer 21 is a flat face, at which a local N-type diffusion region is obtained by ion implantation, with a doping concentration not less than $1 \times 10^{17}$ per cubic centimeter, to form the third charge-carrier transporting layer 22. The third charge-carrier transporting layer 22 has an electron selectivity. The optical regulating layer 30 is provided at the upper surface of the third charge-carrier transporting layer 22. The optical regulating layer 30 is tapped and provided with a series-connecting component 40 to realize the series connection between the upper sub-cell and the lower sub-cell. The fourth charge-carrier transporting layer 23 is provided at the lower surface of the crystalline-silicon light absorbing layer 21, and employs a PERT structure. A back-surface P-type layer is obtained at the lower surface of the crystalline-silicon light absorbing layer 21 by thermal diffusion, with a doping concentration not less than $1 \times 10^{17}$ per cubic centimeter, to form the fourth charge-carrier transporting layer 23. The third charge-carrier transporting layer 22 has a hole selectivity. In addition, the bottom-layer crystalline-silicon sub-cell 20 may also include a passivation anti-reflection layer having the function of lower-surface passivation and anti-reflection, and the passivation anti-reflection layer employs a stack of aluminum oxide, silicon nitride and silicon oxynitride.

The optical regulating layer 30 has a thickness of 283 nanometers, and is of a multilayer structure. The optical regulating layer 30 of the multilayer structure includes a 3-nanometer-thick silicon oxide, a 150-nanometer-thick silicon nitride, a 100-nanometer-thick magnesium fluoride and a 30-nanometer-thick silicon nitride that are sequentially arranged upwardly from the surface of the crystalline-silicon light absorbing layer 21. The first layer of the silicon oxide closely adhered to the surface of the crystalline-silicon light absorbing layer 21 employs wet chemical oxidation, to obtain a good effect of surface passivation. The other layer components are fabricated by physical vapor deposition (sputtering) or chemical vapor deposition. The optical regulating layer 30 is provided with openings, which have hole diameters of 3-5 micrometers and hole spacings of 20-50 micrometers, and are distributed in an array. The area of the projections of the openings in the direction perpendicular to the incidence direction of the light rays does not exceed 80% of the area of the projection of the perovskite light absorbing layer 11. The openings are filled with series-connecting components 40 fabricated by using silver or a silver alloy material. The series-connecting components 40 extend throughout the optical regulating layer 30, and directly contact the second structural layer 13 and the third charge-carrier transporting layer 22, to realize the series connection of the top-layer perovskite sub-cell 10 and the bottom-layer crystalline-silicon sub-cell 20.

In addition, the first electrode 50 is provided at the light facing surface of the perovskite light absorbing layer 11; in other words, one end of the first electrode 50 contacts the perovskite light absorbing layer 11, and the other end penetrates the first charge-carrier transporting layer 12 and protrudes out of the surface of the first charge-carrier transporting layer 12 that is away from the perovskite light absorbing layer 11. The second electrode 60 is provided inside the fourth charge-carrier transporting layer 23; in other words, one end of the second electrode 60 is provided inside the fourth charge-carrier transporting layer 23, and the other end penetrates the fourth charge-carrier transporting layer 23 and protrudes out of the surface of the fourth charge-carrier transporting layer 23 that is away from the crystalline-silicon light absorbing layer 21. The first electrode 50 employs the metals silver, copper or aluminum, or multiple types of metal alloys.

FIG. 14 shows a curve of the reflectivity of a fifth type of the optical regulating layer according to an embodiment of the present application, i.e., a curve of the variation of the reflectivity corresponding to the optical regulating layer 30 included by the tandem solar cell according to the present example with the wavelength of the incident light rays. Referring to FIG. 14, the reflectivity of the optical regulating layer 30 according to the present example to the light rays whose wavelengths are in the range of 600-630 nanometers is greater than 40%, which can realize a good optical-regulation function in the tandem solar cell.

In addition, an embodiment of the present application further provides a photovoltaic assembly, the photovoltaic assembly includes the tandem solar cell according to any one of the above embodiments, the electric connecting components between the cells, the encapsulating material, the border frame and the externally electrically connecting components, and has the same or similar advantageous effects as those of the tandem solar cell stated above.

The embodiments of the present application are described above with reference to the drawings. However, the present application is not limited to the above particular embodiments. The above particular embodiments are merely illustrative, rather than limitative. A person skilled in the art, under the motivation of the present application, can make many variations without departing from the spirit of the present application and the protection scope of the claims, and all of the variations fall within the protection scope of the present application.

**Claims**

1. A tandem solar cell, **characterized in that** the tandem solar cell comprises:

   a top-layer perovskite sub-cell and a bottom-layer crystalline-silicon sub-cell, and an optical regulating layer provided between the top-layer perovskite sub-cell and the bottom-layer crystalline-silicon sub-cell;
   the top-layer perovskite sub-cell is provided at a light facing surface of the tandem solar cell, the bottom-layer crystalline-silicon sub-cell is provided at a shadow surface of the tandem solar cell, and the top-layer perovskite sub-cell and the bottom-layer crystalline-silicon sub-cell are electrically connected to each other; and
   the optical regulating layer is for reflecting at least some of target light rays that pass through the top-layer perovskite sub-cell among sunlight rays back into the top-layer perovskite sub-cell, wherein the target light rays refer to light rays whose wavelengths are in a range of 600-800 nanometers among the sunlight rays.

2. The tandem solar cell according to claim 1, **characterized in that** a maximum value of a reflectivity to the target light rays of the optical regulating layer is greater than or equal to a preset reflectivity.

3. The tandem solar cell according to claim 1, **characterized in that** an average reflectivity to the target light rays of the optical regulating layer is greater than or equal to a preset reflectivity.

4. The tandem solar cell according to claim 1, **characterized in that** reflectivities to all of the target light rays of the optical regulating layer are greater than or equal to a preset reflectivity.

5. The tandem solar cell according to any one of claims 1-4, **characterized in that** the preset reflectivity is 30%-100%.

6. The tandem solar cell according to any one of claims 1-4, **characterized in that** the preset reflectivity is 50±10%.

7. The tandem solar cell according to any one of claims 1-4, **characterized in that** the optical regulating layer comprises at least one low-refractive-index layer and at least one high-refractive-index layer; and
   the at least one low-refractive-index layer and the at least one high-refractive-index layer are separate.

8. The tandem solar cell according to claim 7, **characterized in that** the low-refractive-index layer comprises a low-refractive-index material whose refractive index is less than or equal to a first preset refractive index, and the high-refractive-index layer comprises a high-refractive-index material whose refractive index is greater than or equal to a second preset refractive index, wherein the first preset refractive index is less than or equal to the second preset refractive index; and
   the refractive index of the low-refractive-index material and the refractive index of the high-refractive-index material, a thickness of the low-refractive-index layer and a thickness of the high-refractive-index layer, and a quantity of the low-refractive-index layers and a quantity of the high-refractive-index layers are decided according to the wavelength range of 600-800 nanometers and the preset reflectivity.

9. The tandem solar cell according to claim 8, **characterized in that** a refractive index of the low-refractive-index layer is less than or equal to 1.5, and a refractive index of the high-refractive-index layer is greater than or equal to 1.9.

10. The tandem solar cell according to claim 8, **characterized in that**

    the low-refractive-index material comprises at least one of silicon oxide, silicon oxynitride, sodium fluoride, lithium fluoride, magnesium fluoride, calcium fluoride, sprio-OMe TAD and a fullerene derivative; and
    the high-refractive-index material comprises at least one of carbon-60, diamond, titanium oxide, molybdenum oxide, tungsten oxide, vanadium oxide, zinc oxide, aluminum nitride, zirconium oxide, silicon nitride, silicon oxynitride, aluminum oxynitride, tungsten sulfide, molybdenum sulfide, lead sulfide, boron carbide, silicon carbide, bismuth ferrite, lead iodide, titanium nitride, vanadium nitride, boron phosphide, gallium phosphide, indium phosphide, phosphor germanium zinc, aluminum antimonide, gallium antimonide, indium antimonide, bismuth selenide, molybdenum selenide, lead selenide, tungsten selenide, zinc telluride, lead telluride and molybdenum telluride.

**11.** The tandem solar cell according to any one of claims 1-4, **characterized in that** the top-layer perovskite sub-cell comprises a perovskite light absorbing layer, a first charge-carrier transporting layer, a second charge-carrier transporting layer and a first electrode, and the bottom-layer crystalline-silicon sub-cell comprises a crystalline-silicon light absorbing layer, a third charge-carrier transporting layer, a fourth charge-carrier transporting layer and a second electrode;

the first charge-carrier transporting layer is provided at a light facing surface of the perovskite light absorbing layer, the second charge-carrier transporting layer is provided at a shadow surface of the perovskite light absorbing layer, a charge-carrier selectivity corresponding to the first charge-carrier transporting layer and a charge-carrier selectivity corresponding to the second charge-carrier transporting layer are opposite, and the first electrode is provided on one side of the light facing surface of the perovskite light absorbing layer; the third charge-carrier transporting layer is provided at a light facing surface of the crystalline-silicon light absorbing layer, the fourth charge-carrier transporting layer is provided at a shadow surface of the crystalline-silicon light absorbing layer, a charge-carrier selectivity corresponding to the third charge-carrier transporting layer and a charge-carrier selectivity corresponding to the fourth charge-carrier transporting layer are opposite, and the second electrode is provided on one side of the shadow surface of the crystalline-silicon light absorbing layer; and the charge-carrier selectivity corresponding to the second charge-carrier transporting layer and the charge-carrier selectivity corresponding to the third charge-carrier transporting layer are opposite.

**12.** The tandem solar cell according to claim 11, **characterized in that** the second charge-carrier transporting layer and the third charge-carrier transporting layer are electrically connected to each other, to realize electric connection between the top-layer perovskite sub-cell and the bottom-layer crystalline-silicon sub-cell.

**13.** The tandem solar cell according to claim 12, **characterized in that** the tandem solar cell further comprises an electrically conducting component; and
the second charge-carrier transporting layer and the third charge-carrier transporting layer are electrically connected to each other by the electrically conducting component.

**14.** The tandem solar cell according to claim 13, **characterized in that** a through hole or slot component penetrating the optical regulating layer is provided in the optical regulating layer, the electrically conducting component is provided in the through hole or slot component of the optical regulating layer, one end of the electrically conducting component is connected to the second charge-carrier transporting layer, and the other end of the electrically conducting component is connected to the third charge-carrier transporting layer.

**15.** The tandem solar cell according to claim 14, **characterized in that** a ratio of an area of a projection on the light facing surface of the through hole or slot component in the optical regulating layer to an area of a projection of the optical regulating layer on the light facing surface is less than 20%.

**16.** The tandem solar cell according to claim 13, **characterized in that** the electrically conducting component is provided at a component side position of the tandem solar cell; and
one end of the electrically conducting component is connected to the second charge-carrier transporting layer, and the other end of the electrically conducting component is connected to the third charge-carrier transporting layer.

**17.** The tandem solar cell according to claim 13, **characterized in that** the electrically conducting component comprises at least one of a transparent electrically conductive material, a metal material and a mixed material comprising multiple types of metals, wherein the transparent electrically conductive material comprises at least one of indium tin oxide and aluminum-doped zinc oxide.

**18.** The tandem solar cell according to claim 11, **characterized in that** the optical regulating layer contains an electrically conductive material; and
the second charge-carrier transporting layer and the third charge-carrier transporting layer are electrically connected to each other by the optical regulating layer.

**19.** The tandem solar cell according to claim 11, **characterized in that** the tandem solar cell further comprises a first passivation layer, a first anti-reflection layer and a second passivation layer;

the first passivation layer is provided between the first charge-carrier transporting layer and the perovskite light absorbing layer, and the first anti-reflection layer is provided at one surface of the first charge-carrier transporting layer that is close to the perovskite light absorbing layer; and

the second passivation layer is provided between the second charge-carrier transporting layer and the perovskite light absorbing layer.

20. The tandem solar cell according to claim 11, **characterized in that** the tandem solar cell further comprises a third passivation layer, a fourth passivation layer and a second anti-reflection layer;

the third passivation layer is provided between the third charge-carrier transporting layer and the crystalline-silicon light absorbing layer; and

the fourth passivation layer is provided between the fourth charge-carrier transporting layer and the crystalline-silicon light absorbing layer, and the second anti-reflection layer is provided at one surface of the fourth charge-carrier transporting layer that is close to the crystalline-silicon light absorbing layer.

21. The tandem solar cell according to claim 11, **characterized in that**

one end of the first electrode is provided at a light facing surface of the perovskite light absorbing layer, or provided at a light facing surface of the first charge-carrier transporting layer, or provided inside the first charge-carrier transporting layer, and the other end of the first electrode passes through the first charge-carrier transporting layer and protrudes out of one surface of the first charge-carrier transporting layer that is away from the perovskite light absorbing layer; and

one end of the second electrode is provided at a shadow surface of the crystalline-silicon light absorbing layer, or provided at a shadow surface of the fourth charge-carrier transporting layer, or provided inside the fourth charge-carrier transporting layer, and the other end of the second electrode passes through the fourth charge-carrier transporting layer and protrudes out of one surface of the fourth charge-carrier transporting layer that is away from the crystalline-silicon light absorbing layer.

22. The tandem solar cell according to claim 11, **characterized in that** the third charge-carrier transporting layer is a charge-carrier transporting layer that is obtained by performing in-situ doping to the light facing surface of the crystalline-silicon light absorbing layer, and the fourth charge-carrier transporting layer is a charge-carrier transporting layer that is obtained by performing in-situ doping to the shadow surface of the crystalline-silicon light absorbing layer.

23. A photovoltaic assembly, **characterized in that** the photovoltaic assembly comprises the tandem solar cell according to any one of claims 1-22.

FIG. 1

wavelength (nm)

FIG. 2

external
quantum
efficiency

wavelength (nm)

FIG. 3

FIG. 4

FIG. 5

FIG. 6

FIG. 7

FIG. 8

FIG. 9

wavelength/nm

FIG. 10

FIG. 11

FIG. 12

reflectivity/ %

wavelength/nm

FIG. 13

reflectivity/ %

wavelength/nm

FIG. 14

## INTERNATIONAL SEARCH REPORT

| International application No. |
| --- |
| **PCT/CN2022/095203** |

**A.    CLASSIFICATION OF SUBJECT MATTER**

H01L 51/44(2006.01)i;  H01L 51/42(2006.01)i;  H01L 27/28(2006.01)i;  H01L 27/30(2006.01)i;  H01L 31/068(2012.01)i; H01L 31/0747(2012.01)i;  H01L 31/075(2012.01)i

According to International Patent Classification (IPC) or to both national classification and IPC

**B.    FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS; CNTXT; CNKI; SIPOABS; DWPI; USTXT; WOTXT; EPTXT; Web of Science: 叠层, 层叠, 堆叠, 级联, 串联, 反射, 折射率, 布拉格, 波长, 纳米, 电池, 钙钛矿, 晶硅, tandem, reflect+, refractive index, DBR, wavelength, NM, cell, perovskite

**C.    DOCUMENTS CONSIDERED TO BE RELEVANT**

| Category* | Citation of document, with indication, where appropriate, of the relevant passages | Relevant to claim No. |
| --- | --- | --- |
| X | CN 101286531 A (DELTA ELECTRONICS INC.) 15 October 2008 (2008-10-15) description, page 1, line 20 to page 7, line 18, and figures 1-4 | 1-23 |
| X | MARTINS, A. et al. "Photonic Intermediate Structures for Perovskite/c-Silicon Four Terminal Tandem Solar Cells" *IEEE JOURNAL OF PHOTOVOLTAICS*, Vol. 7, No. 5, 30 September 2017 (2017-09-30), ISSN: 2156-3381, pp. 1190-1195 | 1-23 |
| X | CN 107534066 A (THE REGENTS OF THE UNIVERSITY OF MICHIGAN) 02 January 2018 (2018-01-02) description, paragraphs [0005]-[0032], and figure 2 | 1-23 |
| A | CN 105023921 A (NORTH CHINA ELECTRIC POWER UNIVERSITY) 04 November 2015 (2015-11-04) entire document | 1-23 |

☐ Further documents are listed in the continuation of Box C.       ☑ See patent family annex.

| * | Special categories of cited documents: | | "T" | later document published after the international filing date or priority date and not in conflict with the application but cited to understand the principle or theory underlying the invention |
| --- | --- | --- | --- | --- |
| "A" | document defining the general state of the art which is not considered to be of particular relevance | | | |
| "E" | earlier application or patent but published on or after the international filing date | | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | | |
| "P" | document published prior to the international filing date but later than the priority date claimed | | "&" | document member of the same patent family |

| Date of the actual completion of the international search | Date of mailing of the international search report |
| --- | --- |
| **12 July 2022** | **28 July 2022** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

International application No.

**PCT/CN2022/095203**

| Patent document cited in search report | | | Publication date (day/month/year) | Patent family member(s) | | | Publication date (day/month/year) |
|---|---|---|---|---|---|---|---|
| CN | 101286531 | A | 15 October 2008 | None | | | |
| CN | 107534066 | A | 02 January 2018 | WO | 2016138514 | A1 | 01 September 2016 |
| | | | | EP | 3262693 | A1 | 03 January 2018 |
| | | | | JP | 2018506861 | A | 08 March 2018 |
| | | | | TW | 201705510 | A | 01 February 2017 |
| | | | | US | 2018047922 | A1 | 15 February 2018 |
| | | | | KR | 20170123643 | A | 08 November 2017 |
| | | | | IN | 201717030153 | A | 01 December 2017 |
| CN | 105023921 | A | 04 November 2015 | CN | 105023921 | B | 28 November 2017 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111022824